# EUROPÄISCHE PATENTSCHRIFT

(11) **EP 1 183 728 B1**
(45) Veröffentlichungstag und Bekanntmachung des Hinweises auf die Patenterteilung: **16.04.2008**
(21) Anmeldenummer: 00945613.8
(22) Anmeldetag: 06.06.2000
(51) Int. Cl.: H01L 21/8242

(54) **HALBLEITERSPEICHERBAUELEMENT MIT SPEICHERZELLEN, LOGIKBEREICHEN UND FÜLLSTRUKTUREN**
SEMICONDUCTOR STORAGE COMPONENT WITH STORAGE CELLS, LOGIC AREAS AND FILLING STRUCTURES
COMPOSANT DE MEMOIRE A SEMICONDUCTEURS COMPORTANT DES CELLULES MEMOIRES, DES ZONES LOGIQUES ET DES STRUCTURES DE REMPLISSAGE

(30) Priorität: 08.06.1999 DE 19926106
(43) Veröffentlichungstag der Anmeldung: 06.03.2002
(73) Patentinhaber: Infineon Technologies AG, 81669 München (DE)
(72) Erfinder: SCHINDLER, Günther, D-80802 München (DE); DEHM, Christine, D-90403 Nürnberg (DE)
(74) Vertreter: Barth, Stephan Manuel
(86) Internationale Anmeldenummer: PCT/DE2000/001868
(87) Internationale Veröffentlichungsnummer: WO 2000/079587

(56) Entgegenhaltungen:
- DE-A- 19 935 947
- PATENT ABSTRACTS OF JAPAN vol. 1996, no. 06, 28. Juni 1996 (1996-06-28) & JP 08 046149 A (MATSUSHITA ELECTRON CORP), 16. Februar 1996 (1996-02-16)
- PATENT ABSTRACTS OF JAPAN vol. 1996, no. 10, 31. Oktober 1996 (1996-10-31) & JP 08 162618 A (SONY CORP), 21. Juni 1996 (1996-06-21)
- PATENT ABSTRACTS OF JAPAN vol. 1997, no. 11, 28. November 1997 (1997-11-28) & JP 09 199679 A (NEC CORP), 31. Juli 1997 (1997-07-31) & US 6 004 839 A (NEC CORP) 21. Dezember 1999 (1999-12-21)

## Beschreibung

Die vorliegende Erfindung betrifft ein Halbleiterspeicherbauelement mit Speicherzellen, Logikbereichen und Füllstrukturen gemäß dem Oberbegriff des Anspruches 1, wie aus Patent Abstracts of Japan vol. 1996, no. 6, 28. Juni 1996 & JP 08 046149 A (MATSUSHITA ELECTRON CORP), 16. Februar 1996 bekannt.

Solch ein Halbleiterspeicherbauelement ist ebenfalls aus Patent Abstracts of Japan, vo. 1956, no. 10, 31. Oktober 1996 & JP 08 162618 A (SONY CORP). 21. Juni 1996 bekannt.

Patent Abstracts of Japan, vol. 1997, no. 11, 28. November 1997 & JP 09 199679 A (NEC CORP), 31. Juli 1997 offenbaren eine Halbleitervorrichtung mit leitfähigen Stopfen, wobei mehrere Stopfen aufeinander gesetzt sind.

Derartige Halbleiterspeicherbauelemente mit ferroelektrischem Kondensator oder einem Kondensator mit hoher Dielektrizitätskonstante sind beispielsweise aus der US-A-5,854,104 und EP 0 516 031 A1 bekannt und werden auch als FRAM oder DRAM bezeichnet. Als Material für das Ferroelektrikum des Kondensators kommen beispielsweise SBT (SBT steht für SrBi₂Ta₂O₉) bzw. SBTN (SBTN steht für SrBi₂(Ta₁₋ₓNbₓ)₂O₉) bzw. PZT (PZT steht für Pb(Zrᵢ₋ₓTiₓ)O₃) in Betracht.

Auch betrifft der Gegenstand der Erfindung insbesondere DRAMs, die mit BST arbeiten (BST steht für Ba₁₋ₓSrₓTiO₃) oder Ta₂O₃ als Dielektrikum arbeiten. Diese Materialien benötigen ebenfalls Pt oder ähnliches als Elektrode. Außerdem sind wegen der höheren Integrationsdichten dickere untere Elektroden nötig, um die Seitenwand mitzubenutzen.

Als Material für die dickere Elektrode des Kondensators, welche Elektrode mit dem Transistor der jeweiligen Speicherzelle in Verbindung steht, werden üblicherweise Platin, Iridium, Iridiumdioxid, Ruthenium, Rutheniumdioxid, Palladium, Strontium-Ruthenium-Trioxid oder Kombinationen davon verwendet.

Die Dicke dieser Elektrode, im folgenden auch als untere Elektrode bezeichnet, beträgt mehrere hundert Nanometer, abhängig von der benötigten Kapazität des ferroelektrischen Kondensators. Zur Gesamtdicke der Kondensatorstruktur trägt außerdem das Ferroelektrikum bzw. Material mit hoher Dielektrizitätskonstante bei, das auf die dicke Elektrode abgeschieden ist. Außen auf dem Ferroelektrikum bzw. Material mit hoher Dielektrizitätskonstante ist die Gegenelektrode abgeschieden, die nachfolgend auch als obere Elektrode bezeichnet ist. Insbesondere ergibt sich eine Kondensatorstruktur mit mehreren hundert Nanometern Dicke bzw. Stärke.

Da diese Kondensatorstruktur nur im Zellenfeld des in Rede stehenden Halbleiterspeicherbauelements existieren, während ähnlich dicke Strukturen im Logikbereich des Halbleiterspeicherbauelements nicht vorkommt, ergibt sich ein erheblicher Topologie-Unterschied zwischen den Zellenfeldern und dem restlichen Teil des Halbleiterspeicherbauelements, d.h. den Logikbereichen. Diese Topologie erschwert die Metallisierung des Halbleiterspeicherbauelements bei dessen Herstellung erheblich. Außerdem sind die Ätztiefen durch das Zwischenoxid (obere Oxidschicht) zur oberen Elektrode bzw. zu einem Transistor außerhalb des Zellenfelds stark unterschiedlich.

Eine Aufgabe der vorliegenden Erfindung besteht angesichts dieses Stands der Technik darin, ein Halbleiterspeicherbauelement der eingangs genannten Art zu schaffen, das eine wesentlich gleichmäßigere Topologie zwischen den Zellenfeldern und Logikbereichen aufweist und damit unter anderem problemloser metallisierbar ist.

Gelöst wird diese Aufgabe durch den Gegenstand des Anspruchs 1. Vorteilhafte Weiterbildungen der Erfindung sind in den Unteransprüchen angegeben.

Demnach wird erfindungsgemäß der Topologie-Unterschied zwischen den Speicherzellen und den Logikbereichen dadurch weitgehend ausgeglichen bzw. nivelliert, daß in den Regionen außerhalb der ferroelektrischen Kondensatoren Füllstrukturen vorgesehen sind, deren Dicke bzw. Stärke derjenigen der Kondensatorstrukturen entspricht.

Darüber hinaus ist in Übereinstimmung mit einer vorteilhaften Weiterbildung der Erfindung vorgesehen, die durch Kontaktierungen in den Logikbereichen, die in Verbindung mit den dort vorgesehenen Transistoren stehen, in ähnlicher Weise aufzubauen wie die dicke untere Elektrode der Kondensatoren in den Zellenbereichen. Das heißt, die Kontaktlöcher in der oberen Oxidschicht in den Logikbereichen sind mit demselben Material derselben Dicke gefüllt wie die dicken Kondensator-Elektroden.

Hierdurch ergibt sich insbesondere ein Herstellungsvorteil insofern, als die unteren dicken Kondensator-Elektroden, die Füllstrukturen in den Logikbereichen, die aus demselben Material bestehen wie die dicken Kondensator-Elektroden und die Kontakte in den Kontaktlöchern der Logikbereiche, in ein und demselben Herstellungsschritt ausgebildet werden können. Durch die Verwendung der Kontaktvias in den Logikbereichen wird außerdem die Ätztiefe im Zwischenoxid (obere Oxidschicht) weitgehend angeglichen.

Damit gilt insgesamt, daß der Topologie-Unterschied zwischen den Speicherzellen und den Logikbereichen erfindungsweitgehend ausgeglichen ist, wobei ein Dickenunterschied zugunsten der Speicherzellen ausschließlich in der Dicke des Ferroelektrikums und der oberen Elektrode des jeweiligen Kondensators besteht. Charakteristischerweise beträgt diese Dickendifferenz 200 +/- 100 nm.

Mit anderen Worten besteht die erfindungsgemäße Besonderheit gegenüber dem Stand der Technik in einer Verwendung des Materials für die untere dickere Kondensator-Elektrode sowohl für die Füllstrukturen zum Niveau-Ausgleich wie für die Kontaktvias in den Logikbereichen.

Nachfolgend wird die Erfindung anhand von Ausführungsbeispielen unter Bezugnahme auf die Zeichnungen beispielhaft näher erläutert.

Es zeigen:
- Fig. 1: schematisch in Schnittansicht einen Teil eines nichtflüchtigen Halbleiterspeicherbauelements mit stacked capacitor (Stapelkondensator), in welchem eine Speicherzelle an einen Logikbereich angrenzt, gemäß dem Stand der Technik, und
- Fig. 2: schematisch in Schnittansicht einen Teil eines nichtflüchtigen Halbleiterspeicherbauelements, in welchem eine Speicherzelle an einen Logikbereich angrenzt, gemäß der Erfindung.

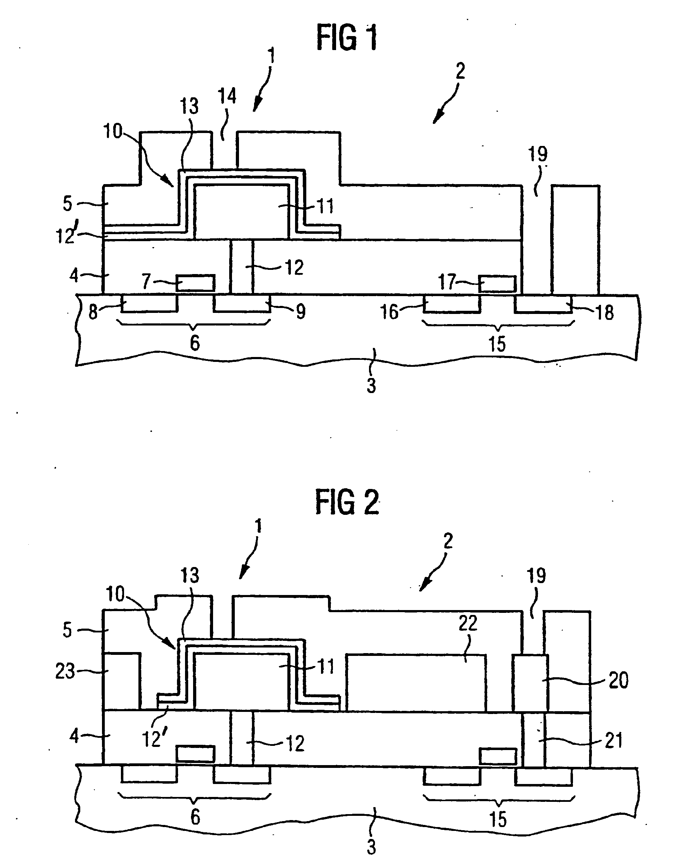

Das in Fig. 1 ausschnittweise gezeigte nichtflüchtige Halbleiterspeicherbauelement umfaßt mehrere Speicherzellen und mehrere Logikbereiche, von denen eine Speicherzelle und ein Logikbereich gezeigt und mit den Bezugsziffern 1 bzw. 2 allgemein bezeichnet sind. Das Halbleiterspeicherbauelement ist in bekannter Weise mehrschichtig aufgebaut und umfaßt als Grundschicht ein Siliziumsubstrat 3, eine Oxidschicht 4, folgend auf das Siliziumsubstrat 3, und eine hierauf folgende obere Oxidschicht 5. Bei der unteren Oxidschicht 4 kann es sich beispielsweise um eine BPSG- oder TEOS-Dünnschicht handeln, während die obere Oxidschicht 5 beispielsweise als TEOS-Dünnschicht bzw. Dünnschicht aus einem Material mit niedriger Dielektrizitätskonstante (z.B. HPCVD-Oxid) oder Kombinationen davon gebildet ist. Die Dicken bzw. Stärken dieser Schichten in vertikaler Richtung betragen typischerweise mehrere tausend Ångström.

Zwischen der unteren Oxidschicht 4 und der oberen Oxidschicht 5 ist üblicherweise eine nicht gezeigte Barrierenschicht vorgesehen, die beispielsweise ebenfalls aus einer TiO₂-Dünnschicht besteht.

Bei FeRAMs bzw. DRAMs mit Materialien mit hoher Dielektrizitätskonstante kommen zwei Barrieren zum Einsatz, die unterschieden werden müssen. Erstens eine Barriere zwischen der unteren Elektrode 11 und dem Plug 12. Diese Barriere soll eine Oxidation des Plugs 12 (meist aus Polysilizium) während des Annealens der Schicht 12' verhindern. Materialien für die Barriere sind TiN, TaN, TiSiN, TiAlN, TaSiN, IrO₂. Zweitens gibt es die H₂-Barriere über dem Kondensator, welche ein Eindringen von H₂ während der Metallisierung (z.B. W-Abscheidung) verhindern soll, und damit eine Schädigung der Schicht 12. Diese Schicht liegt auf der oberen Elektrode 13. Sie kann in Bereichen außerhalb der Kondensatoren auch auf der Schicht 4 zu liegen kommen. Typische Materialien sind Si₃N₄ oder Al₂O₃. TiO₂ ist nicht sehr geeignet, da es schwer ätzbar ist und diese Barrierenschicht in den Kontaktlöchern 14 und 19 geätzt werden muß.

Die Speicherzelle 1 umfaßt einen Transistor 6, bevorzugt einen MOSFET-Transistor mit einem Gate 7, einer Source 8 und einem Drain 9. Source 8 und Drain 9 sind im Siliziumsubstrat 3 angrenzend an die untere Oxidschicht 4 gebildet, während das Gate 7 in der unteren Oxidschicht 4 gebildet ist.

Die Speicherzelle 1 umfaßt außerdem einen ferroelektrischen Kondensator 10, der aus einer unteren dicken Elektrode 11 besteht, die mit dem Drain 9 des Transistors 6 über ein Via 12 verbunden ist, bei dem es sich um ein die untere Oxidschicht 4 durchsetzendes Kontaktloch handelt, welches mit einem elektrisch gut leitenden Metall gefüllt ist. Als Material für die untere Elektrode 11 des Kondensators 10 kommt beispielsweise Platin oder Iridium sowie die o.g. weiteren Materialien in Betracht, und bevorzugt ist das Material des Vias 12 Polysilizium oder W. Die untere dicke Elektrode 11 des Kondensators 10 ist mit einem Ferroelektrikum bzw. Material mit einer hohen Dielektrizitätskonstante 12' beschichtet, welches den dicken Körper der unteren Elektrode 11 allseitig umschließt und sich am Fuß dieser Elektrode außerdem seitlich auf der Oberseite der unteren Oxidschicht 4 mit einer bestimmten Ausdehnung erstreckt. Der Kondensator 10 umfaßt außerdem eine Elektrode 13, die als relativ dünne Schicht das Dielektrikum 12' abdeckt und wesentlich dünner ist als die untere Elektrode 11. Zur Kontaktierung der oberen Elektrode 13 des Kondensators 10 ist in der oberen Oxidschicht 5 ein Kontaktloch 14 gebildet.

Im Logikbereich 2 ist ein weiterer Transistor 15 angeordnet, der bevorzugt ebenfalls als MOSFET gebildet ist, und eine Source 16, ein Gate 17 und einen Drain 18 umfaßt. Die Anordnung von Gate, Source und Drain des Transistors 15 ist dieselbe wie beim Transistor 6; d.h., Gate 17 und Drain 18 sind im Siliziumsubstrat 3 angeordnet, während das Gate 17 in der unteren Oxidschicht 4 angeordnet ist. Zur Kontaktierung des Drain 18 des Transistors 15 ist ein Kontaktloch 19 vorgesehen, welches die untere Oxidschicht 4 und die obere Oxidschicht 5 vollständig durchsetzt und in die Oberseite des oberen Oxids 5 mündet.

Aus Fig. 1 geht hervor, daß zwischen der Speicherzelle 1 und dem Logikbereich 2 ein starker Niveau-Unterschied bzw. Topologie-Unterschied vorliegt, der zu dem eingangs genannten Nachteil führt, daß die Metallisierung dieses Bauteils erheblich erschwert ist und die Ätztiefen durch das Zwischenoxid bzw. die obere Oxidschicht 5 zur oberen Elektrode bzw. beim Transistor außerhalb des Zellenfelds 1 sehr unterschiedlich ist.

Diese Nachteile werden durch den erfindungsgemäßen Aufbau des Halbleiterspeicherbauelements gemäß Fig. 2 überwunden. Fig. 2 zeigt eine ähnliche Teilansicht eines nichtflüchtigen Halbleiterspeicherbauelements wie in Fig. 1, wobei diejenigen Bestandteile von Fig. 2, die denjenigen von Fig. 1 entsprechen, mit denselben Bezugsziffern bezeichnet sind. Im folgenden ist lediglich der Unterschied zwischen den Anordnungen von Fig. 1 und 2 erläutert.

Demnach ist in dem Kontaktloch 19 eine Struktur vorgesehen, die in ihrer Zusammensetzung der Struktur der unteren Elektrode 11 des Kondensators 10 und des Vias 12 entspricht. Das heißt, im Bereich der oberen Oxidschicht 5 ist in dem Kontaktloch 19 ein Materialstopfen 20 angeordnet, der dieselbe Dicke bzw. Stärke aufweist wie die untere Elektrode 11 des Kondensators 10 und im unteren Bereich des Kontaktlochs 11 ist innerhalb der unteren Oxidschicht 4 ein weiterer Stopfen 21 vorgesehen, welcher der Materialfüllung des Vias 12 entspricht. Zwischen der unteren dicken Elektrode 11 des Kondensators 10 und dem Materialstopfen 20 ist aus demselben Material und in derselben Dicke bzw. Stärke wie diese Elemente eine Füllstruktur 22 vorgesehen, die sich an die Barriereschciht auf der unteren Oxidschicht 4 anschließt. Eine weitere Füllstruktur 23 dieser Art ist auf der anderen Seite des Kondensators 10, in Fig. 2 links von dem vorgesehen und mit der Bezugsziffer 23 bezeichnet.

Wie aus einem Vergleich von Fig. 1 und Fig. 2 hervorgeht, besitzt die Anordnung von Fig. 2 eine Topologie, die weitgehend ausgeglichen verläuft; d.h., zwischen der Speicherzelle 1 und dem Logikbereich 2 besteht so gut wie kein Niveau-Unterschied, abgesehen von dem Niveau-Unterschied, der sich dadurch ergibt, daß die untere dicke Elektrode 11 des Kondensators 10 mit dem Dielektrikum 12 und der oberen Elektrode 13 beschichtet ist. Infolge dieser ausgeglichenen Topologie läßt sich die notwendige Planarisierung durch chemisch-mechanisches Polieren für die erforderliche Metallisierung problemlos durchführen und die Ätztiefe durch das Zwischenoxid bzw. die obere Oxidschicht 5 zur oberen Elektrode bzw. zu einem Transistor außerhalb des Zellenfelds 1 ist sehr gleichmäßig.

Obwohl die vorliegende Erfindung vorstehend anhand bevorzugter Ausführungsbeispiele beschrieben wurde, ist sie darauf nicht beschränkt, sondern auf vielfältige Art und Weise modifizierbar.

Eine weitere Möglichkeit ist die sogenannte Offset-Struktur, bei der der Kondensator und der Transistor von oben durch die Metallisierung über die obere Elektrode verbunden sind.

## Patentansprüche

1. Halbleiterspeicherbauelement mit Speicherzellen, Logikbereichen und Füllstrukturen mit wahlfreiem Zugriff, aufweisend eine in Speicherzellen (1) und Logikbereiche (2) differenzierte Struktur mit einer auf einem Siliziumsubstrat (3) angeordneten unteren Oxidschicht (4) und einer auf dieser angeordneten oberen Oxidschicht (5), wobei jede Speicherzelle (1) zumindest einen ersten Transistor (6) im Übergangsbereich zwischen Siliziumsubstrat (3) und unterer Oxidschicht (4) und einen Kondensator (10) im Übergangsbereich zwischen unterer und oberer Oxidschicht (4, 5) umfaßt, der über ein mit einem ersten leitfähigen Material gefülltes erstes Kontaktloch (12) in der unteren Oxidschicht (4) in Verbindung mit dem ersten Transistor (6) steht und ein zwischen zwei Elektroden (11, 13) angeordnetes Ferroelektrikum (12') umfaßt, wobei die mit dem ersten Transistor (6) verbundene, an die untere Oxidschicht (4) angrenzende untere Elektrode (11) eine relativ große Stärke aufweist, und wobei jeder Logikbereich (2) zumindest einen zweiten Transistor (15) im Übergangsbereich zwischen Siliziumsubstrat (3) und unterer Oxidschicht (4) umfaßt, der über ein mit einem zweiten leitfähigen Material gefülltes zweites Kontaktloch (19) in der unteren und der oberen Oxidschicht (4, 5) mit einer dritten Elektrode auf der Oberseite der oberen Oxidschicht (5) in Verbindung steht, wobei zwischen den Kondensatoren (10) der Speicherzellen (1) und den zweiten Kontaktlöchern (19) in den Logikbereichen (2) durch Füllstrukturen (22, 23) ein Niveauausgleich zwischen der Topologie der Speicherzellen (1) und der Logikbereiche (2) geschaffen ist,
**dadurch gekennzeichnet,**
**daß** in dem zweiten Kontaktloch (19) eine Struktur vorgesehen ist, die in ihrer Zusammensetzung der Struktur der unteren Elektrode (11) des Kondensators (10) und des ersten Kontaktlochs (12) entspricht, indem im Bereich der oberen Oxidschicht (5) in dem zweiten Kontaktloch (19) ein Materialstopfen (20) angeordnet ist, der dieselbe Stärke aufweist wie die untere Elektrode (11), und im unteren Bereich des zweiten Kontaktlochs (19) innerhalb der unteren Oxidschicht (4) ein weiterer Stopfen (21) vorgesehen ist, der der Materialfüllung des ersten Kontaktlochs (12) entspricht.

2. Halbleiterspeicherbauelement nach Anspruch 1,
**dadurch gekennzeichnet,**
**daß** als Offset-Struktur der Kondensator (10) und der erste Transistor (6) von oben durch eine Metallisierung über die obere Elektrode verbunden sind.

3. Halbleiterspeicherbauelement nach Anspruch 1 oder 2,
**dadurch gekennzeichnet ,**
**daß** die Füllstruktur (22, 23) Materialinseln einer Stärke im wesentlichen entsprechend derjenigen der dicken unteren Kondensator-Elektroden (11) umfaßt.

4. Halbleiterspeicherbauelement nach Anspruch 2 oder 3
**dadurch gekennzeichnet,**
**daß** die Füllstruktur-Inseln (22, 23) aus demselben Material bestehen wie die dicken unteren Kondensatoren-Elektroden (11).

5. Halbleiterspeicherbauelement nach Anspruch 1, 2, 3 oder 4,
**dadurch gekennzeichnet ,**
**daß** die zweiten Kontaktlöcher (19) in den Logikbereichen (2) zur Verbindung der zweiten Transistoren (15) der Logikbereiche (2) mit den zugehorigen dritten Elektroden auf der Oberseite der oberen Oxidschicht (5) zumindest im Bereich der oberen Oxidschicht (5) aus dem Material der dicken unteren Kondensator-Elektroden (11) in im wesentlichen derselben Stärke wie diese bestehen.

6. Halbleiterspeicherbauelement nach einem der vorangehenden Ansprüche,
**dadurch gekennzeichnet,**
**daß** die Kontaktlöcher (12, 19) auch in der unteren Oxidschicht (4) aus dem Metallmaterial bestehen, aus welchem die dicken unteren Kondensator-Elektroden (11) bestehen.

7. Halbleiterspeicherbauelement nach einem der vorangehenden Ansprüche,
**dadurch, gekennzeichnet,**
**daß** die dünnen oberen Kondensator-Elektroden (13) aus demselben Metallmaterial bestehen wie die dicken unteren Kondensator-Elektroden (11).

8. Halbleiterspeicherbauelement nach einem der vorangehenden Ansprüche,
**dadurch, gekennzeichnet,**
**daß** die dicken unteren Kondensator-Elektroden (11) aus Platin, Iridium, Iridiumdioxid, Ruthenium, Rutheniumdioxid, Palladium, Strontium-Ruthenium-Trioxid oder Kombinationen davon bestehen.

## Claims

1. Semiconductor memory component, having memory cells, logic regions and dummy structures with random access, also having a structure which is differentiated into memory cells (1) and logic regions (2) and has a lower oxide layer (4) arranged on a silicon substrate (3) and an upper oxide layer (5) arranged on the lower oxide layer, each memory cell (1) comprising at least one first transistor (6) in the transition region between silicon substrate (3) and lower oxide layer (4) and a capacitor (10) in the transition region between lower oxide layer (4) and upper oxide layer (5), which capacitor is connected to the first transistor (6) via a first contact hole (12), which is filled with a first conductive material, in the lower oxide layer (4) and comprises a ferroelectric (12') arranged between two electrodes (11, 13), the lower electrode (11) which is connected to the first transistor (6) and adjoins the lower oxide layer (4) having a relatively great thickness, and each logic region (2) comprising at least one second transistor (15) in the transition region between silicon substrate (3) and lower oxide layer (4), which transistor is connected to a third electrode on the topside of the upper oxide layer (5) via a second contact hole (19), which is filled with a second conductive material, in the lower oxide layer (4) and the upper oxide layer (5), wherein between the capacitors (10) of the memory cells (1) and the second contact holes (19) in the logic regions (2), level compensation between the topology of the memory cells (1) and of the logic regions (2) is created by dummy structures (22, 23), **characterized in that** in the second contact hole (19) is provided a structure, the composition of which corresponds to the structure of the lower electrode (11) of the capacitor (10) and of the first contact hole (12), by a plug of material (20) which is of the same thickness as the lower electrode (11) being arranged in the second contact hole (19) in the region of the upper oxide layer (5), and a further plug (21), which corresponds to the material filling the first contact hole (12), being provided in the lower region of the second contact hole (19), inside the lower oxide layer (4).

2. Semiconductor memory component according to Claim 1, **characterized in that**, as an offset structure, the capacitor (10) and the first transistor (6) are connected from above by a metallization over the upper electrode.

3. Semiconductor memory component according to Claim 1 or 2, **characterized in that** the dummy structure (22, 23) comprises islands of material with a thickness which substantially corresponds to that of the thick lower capacitor electrodes (11).

4. Semiconductor memory component according to Claim 2 or 3, **characterized in that** the dummy structure islands (22, 23) consist of the same material as the thick lower capacitor electrodes (11).

5. Semiconductor memory component according to Claim 1, 2, 3 or 4, **characterized in that** the second contact holes (19) in the logic regions (2), in order to connect the second transistors (15) of the logic regions (2) to the associated third electrodes on the topside of the upper oxide layer (5), at least in the region of the upper oxide layer (5) consist of the same material as the thick lower capacitor electrodes (11), with substantially the same thickness as the latter.

6. Semiconductor memory component according to one of the preceding claims, **characterized in that** the contact holes (12, 19) in the lower oxide layer (4) also consist of the metal material from which the thick lower capacitor electrodes (11) are formed.

7. Semiconductor memory component according to one of the preceding claims, **characterized in that** the thin upper capacitor electrodes (13) consist of the same metal material as the thick lower capacitor electrodes (11).

8. Semiconductor memory component according to one of the preceding claims, **characterized in that** the thick lower capacitor electrodes (11) consist of platinum, iridium, iridium dioxide, ruthenium, ruthenium dioxide, palladium, strontium-ruthenium trioxide or combinations thereof.

## Revendications

1. Composant mémoire semi-conducteur comprenant des cellules mémoire, des zones logiques et des structures de remplissage avec accès aléatoire, comprenant une structure différenciée entre cellules mémoire (1) et zones logiques (2) avec une couche d'oxyde (4) inférieure disposée sur un substrat de silicium (3) et une couche d'oxyde (5) supérieure disposée sur celle-ci, chaque cellule mémoire (1) comprenant au moins un premier transistor (6) dans la zone de transition entre le substrat de silicium (3) et la couche d'oxyde (4) inférieure et un condensateur (10) dans la zone de transition entre la couche d'oxyde (4, 5) inférieure et supérieure, le condensateur étant relié, via un premier trou de contact (12) dans la couche d'oxyde (4) inférieure, rempli d'un premier matériau semi-conducteur, avec le premier transistor (6) et comprenant un ferroélectrique (12') disposé entre deux électrodes (11, 13), l'électrode inférieure (11) reliée avec le premier transistor (6) et adjacente à la couche d'oxyde (4) inférieure présentant une épaisseur relativement importante et chaque zone logique (2) comprenant au moins un deuxième transistor (15) dans la zone transitoire entre le substrat de silicium (3) et la couche d'oxyde (4) inférieure, le deuxième transistor étant relié via un deuxième trou de contact (19) dans la couche d'oxyde (4, 5) inférieure et supérieure, rempli d'un deuxième matériau semi-conducteur, avec une troisième électrode sur le coté supérieur de la couche d'oxyde (5) supérieure, un équilibrage de niveau entre la topologie des cellules mémoire (1) et les zones logiques (2) étant réalisé par des structures de remplissage (22, 23), entre les condensateurs (10) des cellules mémoire (1) et les deuxièmes trous de contact (19) dans les zones logiques (2),
**caractérisé en ce qu'**
une structure est prévue dans le deuxième trou de contact (19), celle-ci correspond dans sa composition à la structure de l'électrode inférieure (11) du condensateur (10) et du premier trou de contact (12), en disposant un tampon de matériau (20) dans la zone de la couche d'oxyde (5) supérieure dans le deuxième trou de contact (19), celui-ci ayant la même épaisseur que l'électrode inférieure (11), et en prévoyant un autre tampon (21) dans la zone inférieure du deuxième trou de contact (19) à l'intérieur de la couche d'oxyde inférieure (4), celui-ci correspondant au remplissage du premier trou de contact (12).

2. Composant mémoire semi-conducteur selon la revendication 1,
**caractérisé en ce que**
le condensateur (10) et le premier transistor (6) sont reliés, comme une structure Offset, par le haut, par une métallisation, via l'électrode supérieure.

3. Composant mémoire semi-conducteur selon la revendication 1 ou 2,
**caractérisé en ce que**
la structure de remplissage (22, 23) comporte des îlots d'une épaisseur correspondant essentiellement à celles des électrodes inférieures et épaisses du condensateur (11).

4. Composant mémoire semi-conducteur selon la revendication 2 ou 3,
**caractérisé en ce que**
les îlots de structure de remplissage (22, 23) sont réalisés avec le même matériau que les électrodes (11) du condensateur inférieures et épaisses.

5. Composant mémoire semi-conducteur selon la revendication 1, 2, 3 ou 4,
**caractérisé en ce que**
les deuxièmes trous de contact (19) dans les zones logiques (2), pour la connexion des deuxièmes transistors (15) des zones logiques (2) avec les troisièmes électrodes correspondantes sur le coté supérieur de la couche d'oxyde (5) supérieure, sont réalisés avec le matériau et essentiellement avec l'épaisseur des électrodes (11) du condensateur inférieures et épaisses, au moins dans la zone de la couche d'oxyde (5) supérieure.

6. Composant mémoire semi-conducteur selon l'une quelconque des revendications précédentes,
**caractérisé en ce que**
les trous de contact (12, 19) aussi dans la couche d'oxyde inférieure (4) sont réalisés avec le matériau métallique à partir duquel sont réalisées les électrodes de condensateur (11) inférieures et épaisses.

7. Composant mémoire semi-conducteur selon l'une quelconque des revendications précédentes,
**caractérisé en ce que**
les électrodes de condensateur supérieures et fines (13) sont réalisées avec le même matériau métallique que les électrodes de condensateur (11) inférieures et épaisses.

8. Composant mémoire semi-conducteur selon l'une quelconque des revendications précédentes,
**caractérisé en ce que**
les électrodes de condensateur inférieures et épaisses (11) sont réalisées en platine, iridium, dioxyde d'iridium, ruthénium, dioxyde de ruthénium, palladium, trioxyde de strontium-ruthénium ou d'une combinaison de ceux-ci.
